Europäisches Patentamt

European Patent Office

Office européen des brevets

(11) Veröffentlichungsnummer: **0 234 273**
**A2**

(12) **EUROPÄISCHE PATENTANMELDUNG**

(21) Anmeldenummer: **87100797.7**

(22) Anmeldetag: **21.01.87**

(51) Int. Cl.⁴: **G01R 31/28** , G05B 23/00 , G06F 11/22

(30) Priorität: **20.02.86 DE 3605431**

(43) Veröffentlichungstag der Anmeldung:
**02.09.87 Patentblatt 87/36**

(84) Benannte Vertragsstaaten:
**DE FR GB IT**

(71) Anmelder: **VDO Adolf Schindling AG**
**Gräfstrasse 103**
**D-6000 Frankfurt/Main(DE)**

(72) Erfinder: **Ohm, Heinz-Friedrich**
**Berliner Strasse 9**
**D-6108 Weiterstadt(DE)**
Erfinder: **Reisch, Wolfgang**
**Röderichstrasse 4**
**D-6000 Frankfurt am Main(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Prüfbares elektronisches Gerät und Verfahren zum Prüfen eines solchen Geräts.**

(57) In einem Verfahren zum Prüfen eines elektronischen Geräts, insbesondere für Kraftfahrzeuge, mit einem Mikrocomputer (2), einer Schnittstelle sowie Geräteein-und Ausgängen (Stecker 6) sind folgende getrennte Prüfschritte vorgesehen: In einem Prüfschritt wird in die Geräteeingänge (Stecker 6) mindestens eine vorgegebene Kombination von Eingangssignalen eingespeist, die an Eingängen von Hardware-Einheiten (4, 8, 9) des Geräts (I) dabei auftretenden Testausgangssignale werden über die Schnittstelle abgefragt und extern mit der Kombination der Eingangssignale verglichen. In weiteren Testschritten werden in jeweils eine Hardware-Einheit Teststeuersignale eingespeist und die dadurch am Ausgang dieser Hardware-Einheit entstehenden Testausgangssignale über die Schnittstelle zu einem externen Soll-Ist-Vergleich abgefragt. In einem weiteren Prüfschritt werden in wenigstens eine mit den Geräteausgängen in Verbindung stehende Hardware-Ein heit (2, 3) Ausgangsteststeuersignale eingespeist und die dadurch an den Geräteausgängen (Stecker 6) erzeugten Ausgangssignale zu einem externen Soll-Ist-Vergleich abgegeben.

Fig. 1

## Prüfbares elektronisches Gerät und Verfahren zum Prüfen eines solchen Geräts

Die Erfindung betrifft ein prüfbares elektronisches Gerät, insbesondere für Kraftfahrzeuge, nach dem Oberbegriff des Anspruchs I. Damit im Zusammenhang betrifft ein weiterer Aspekt der Erfindung ein Verfahren zum Prüfen eines solchen Geräts nach dem Oberbegriff des Anspruchs 5.

Elektronische Geräte, insbesondere für Kraftfahrzeuge, werden immer komplexer, woraus bei herkömmlichen Prüfeinrichtungen und Prüfverfahren länger werdende Prüfzeiten und damit höhere Produktionskosten resultieren. Solche elektronische Geräte für Kraftfahrzeuge können beispielsweise Geschwindigkeitsregler sein oder Steuergeräte zur Übertragung einer Gaspedalstellung auf eine Drosselklappe. Diese Geräte, auf die sich die Erfindung speziell bezieht, enthalten einen Mikrocomputer sowie eine Schnittstelle zum Anschluß an weitere Geräte, beispielsweise an den Geber der Gaspedalstellung, der die Eingangssignale liefert, und ein Stellorgan der Drosselklappe, welches bei den Ausgangssignalen beaufschlagt wird. Die entsprechenden Eingänge und Ausgänge des Geräts werden häufig durch Kontakte eines Steckers gebildet.

Bisher wurden solche elektronischen Geräte in der Weise geprüft, daß in die Eingänge vorgegebene Eingangssignale eingespeist werden und die Ausgangssignale ausgewertet wurden. Die Prüfung erstreckte sich dabei also auf das Gerät in seiner Gesamtheit, einschließlich hierin eingespeicherter Programme. Dieses Prüfverfahren erforderte zwar in der Regel keine besondere Ausbildung des elektronischen Geräts für die Prüfung, war jedoch auch deswegen zeitraubend, da nach der Eingabe von Eingangssignalen unter Umständen längere Zeiten abzuwarten waren, welche durch die normalen Gerätefunktionen bedingt sind, z.B. durch das Zeitverhalten von Reglern, die unter Umständen Verzögerungszeiten von einigen Minuten aufweisen können. Ebenso sind Einschwingvorgänge abzuwarten. Nachteilig war es bei der Prüfung der Geräte jeweils in ihrer Gesamtheit auch, daß fehlerhafte Ausgangssignale unter Umständen schwierig zu interpretieren waren und die genaue Lokalisierung des Fehlers längere Nacharbeiten bedingte.

Der Erfindung liegt daher die Aufgabe zugrunde, ein prüfbares elektronisches Gerät, insbesondere für Kraftfahrzeuge, der eingangs genannten Gattung zu schaffen, das schnell und mit genauer Lokalisierung des Fehlers geprüft werden kann.

Diese Aufgabe wird durch die Ausbildung des prüfbaren elektronischen Geräts mit den Merkmalen des kennzeichnenden Teils des Anspruchs I gelöst.

Mit dieser Ausbildung des prüfbaren Geräts wird die wesentliche Voraussetzung dafür geschaffen, daß dieses nicht mehr als Gesamtsystem zusammenhängend geprüft werden muß, sondern daß die Prüfung für die einzelnen Hardware-Einheiten des Geräts jeweils getrennt durchgeführt werden kann. Insbesondere erfolgt die getrennte Prüfung entlang dem Signalweg von dem Eingang bis zu dem Ausgang des Geräts. Grundsätzlich ist jedoch die Abfolge der Prüfung der einzelnen Hardware-Einheiten unabhängig voneinander. Diese elektronischen Geräte eignen sich gut zur Prüfung mit automatisierten Prüfverfahren. Vorteilhaft ist, daß die Prüfung nicht durch das Abwarten von Gerätebedingtem Zeitverhalten verzögert werden muß, da die entsprechenden Zeitglieder durch die getrennte Ansteuerbarkeit der einzelnen Hardware-Einheiten praktisch umgangen werden können. Die Prüfung der einzelnen Hardware-Einheiten ergibt zugleich eine genaue Lokalisierung des Fehlers, da der bei einem Prüfvorgang auftretende Fehler auf die jeweils geprüfte Hardware Einheit begrenzt sein muß. Die bei einem Prüfschritt zugeordneten Fehler können einfach gespeichert und dokumentiert werden. Durch die getrennte Ansteuerung der einzelnen Hardware-Einheiten und die Auswertung der bei der Ansteuerung dieser Hardware-Einheiten entstehenden Testausgangssignale wird bewußt auf die Prüfung einer in dem Gerät für dessen einsatzmäßige Funktion gespeicherte Software weitgehend verzichtet. Auch dadurch wird der Prüfvorgang beschleunigt und die Fehlersuche vereinfacht. Auf die Prüfung dieses sogenannten Hauptprogramms des Geräts kann deswegen im wesentlichen verzichtet werden, da die für alle Geräte gleiche Software während der Entwicklungs-und Erprobungsphase ausreichend getestet wurde. Die einzelnen Einheiten des zu prüfenden elektronischen Geräts werden daher hier als Hardware-Einheiten bezeichnet.

Die Prüfbarkeit dieses elektronischen Geräts ist nicht auf die sich der Produktion unmittelbar anschließende Phase zwangsläufig beschränkt, sondern kann auch später gegebenen falls bei einer während seines normalen Einsatzes auftretenden Störung wiederholt werden.

Da das Gesamtsystem des elektronischen Geräts zur Prüfung in einzelne Hardware-Einheiten unterteilt ist, können diesen Hardware-Einheiten spezielle Steuersignale zugeführt werden, welche Testausgangssignale erwarten lassen. Es ist in dieser Weise durch Test der einzelnen Hardware-Einheiten in einer Abfolge von Prüfschritten eine praktisch vollständige Prüfung des gesamten Geräts möglich, es können aber auch weniger störanfällige Hardware-Einheiten von einer Prüfung ausgenommen werden.

Die Auswertung der an der Schnittstelle des Geräts abfragbaren Testausgangssignale, die bei der Prüfung je einer Hardware-Einheit entstehen, erfolgt in einer Testhaupteinrichtung durch Soll-Ist-Vergleich. Die Testhaupteinrichtung ist zur Steuerung der in den einzelnen Hardware-Einheiten aufeinanderfolgend ablaufenden Prüfvorgänge über eine Leitung mit einer funktionellen Schnittstelle des zu prüfenden Geräts verbunden. Die Leitung kann eine serielle Verbindung darstellen, über die das prüfbare elektronische Gerät mit der Testhaupteinrichtung kommuniziert. Die Haupttesteinrichtung weist dazu eine passende funktionelle Schnittstelle auf. Im Rahmen dieser Anmeldung umfaßt der Begriff Schnittstelle des Geräts aber nicht nur eine funktionelle, steuerbare Schnittstelle, die durch Halbleiter realisiert sein kann, sondern vor allem den Stecker des Geräts, über dessen Kontakte die Hardware-Einheiten des Geräts getrennt ansteuerbar sind und an dem die Testausgangssignale abgegriffen werden können.

Bei der Prüfung bestimmter Hardware-Einheiten an den Geräte ausgängen entstehende Ausgangssignale werden vorzugsweise nicht unmittelbar zum Soll-Ist-Vergleich in der Testhaupteinrichtung herangezogen, sondern in einem zwischengeschalteten Meßadapter, der ebenfalls mit der Testhaupteinrichtung kommuniziert, vorher umgesetzt, um einen einfachen Vergleich zu ermöglichen. Der Meßadapter kann weiter dazu eingerichtet sein, durch die Testhaupteinrichtung gesteuert Eingangssignale zu Prüfzwecken an das prüfbare elektronische Gerät abzugeben, welche in das Gerät, bzw. in den Stecker des Geräts so eingespeist werden wie betriebsmäßig auftretende Eingangssignale.

Zweckmäßig weist das prüfbare elektronische Gerät nach Anspruch 2 einen Speicher auf, in dem Teststeuerdaten eines Testprogramms gespeichert sind. Mit diesem Testprogramm können in dem Gerät Teststeuersignale in einer Folge erzeugt werden, mit denen nacheinander einzelne Hardware-Einheiten beaufschlagt werden, um Testausgangssignale zu liefern, welche in der synchronisierten Testhaupteinrichtung ausgewertet werden können. Dazu wird das Testprogramm in dem prüfbaren Gerät über die Schnittstellen des Geräts und der Testhaupteinrichtung oder über spezielle Signalleitungen aktiviert.

Da die Teststeuerdaten des Testprogrammes in dem prüfbaren Gerät nicht sämtliche Gerätefunktionen des Geräts auslösen müssen, wird zu deren Speicherung nur ein verhältnismäßig geringer Speicherbedarf benötigt. Die Teststeuerdaten können daher in einem Speicherbereich z.B. eines ROM ständig gespeichert sein.

Es ist aber auch möglich, wenn der gesamte in einem Gerät zur Verfügung stehende Speicherraum für das Hauptprogramm benötigt wird, welches die Gerätefunktionen im Betrieb bestimmt, vor dem betriebsmäßigen Einsatz des Geräts die Teststeuerdaten anstatt des Hauptprogramms zu speichern, wenn ein löschbarer Speicher, z.B. ein EROM vorgesehen ist. Dies ist ein weiterer Vorteil der gezielten Hardware-mäßigen Prüfung. insbesondere genügt es, eine Einheit des Geräts, welche eine Informationsverknüpfung bewirkt, nur Hardwaremäßig zu prüfen, beispielsweise ein Rechenwerk nur durch ein Rechenbeispiel, welches keine Befehlsfolge voraussetzt, oder einen ROM Speicher auf die Abspeicherung der richtigen Daten. Außer diesen Einheiten eines Mikroprozessors kann auch ein Programmspeicher als Hardware-Einheit geprüft werden, indem dieser mit Teststeuersignalen beaufschlagt wird, welche eine Checksumprüfung in der Testhaupteinrichtung ermöglichen, oder eine Programmübertragung zu der Testhaupt einrichtung, indem ein Soll-Ist-Vergleich erfolgt.

Das Wesen des Prüfverfahrens, mit dem das gemäß den vorangehenden Ansprüchen gekennzeichnete Gerät geprüft wird, ist in Anspruch 5 angegeben. Zusammenfassend wird mit dem Prüfschritt a der Teil des Geräts von seinen Eingängen an einem vorhandenen Stecker, in den die Eingangssignale eingespeist werden, bis zu mit dem Stecker in Verbindung stehenden Punkten in dem Gerät geprüft, an denen die Eingangssignale erscheinen sollen und von denen zur Prüfung die entsprechen den Testausgangssignale über die Schnittstelle abgefragt werden. Die Prüfung der weiteren Hardware-Einheiten in dem Gerät selbst erfolgt, wie voranstehend im Zusammenhang mit den Geräten geschildert, mit dem rüfschritt b. Die Teststeuersignale, die durch die in einem Speicherbereich gespeicherten Teststeuerdaten in dem Gerät erzeugt werden können, ermöglichen eine Hardware-mäßige Prüfung der einzel nen Hardware-Einheiten. Zur Prüfung der Verbindung der Hardware-Einheiten mit den Geräteausgängen an den Kontakten des Gerätesteckers ist der Prüfschritt c vorgesehen. Damit an diesen Geräteausgängen Ausgangssignale erscheinen, werden in einer den Geräteausgängen vorgeschalteten Hardware-Einheit Ausgangsteststeuersignale eingespeist, die somit einen Sonderfall der Teststeuersignale darstellen und in grundsätzlich gleicher Weise wie diese erzeugt werden können.

Die Erfindung wird im folgenden anhand einer Zeichnung mit zwei Figuren erläutert:

Es zeigt Fig. I ein Ausführungsbeispiel eines prüfbaren elektronischen Geräts in vereinfachter Darstellung und in Verbindung mit einer Testhaupteinrichtung sowie einem Meßadapter und

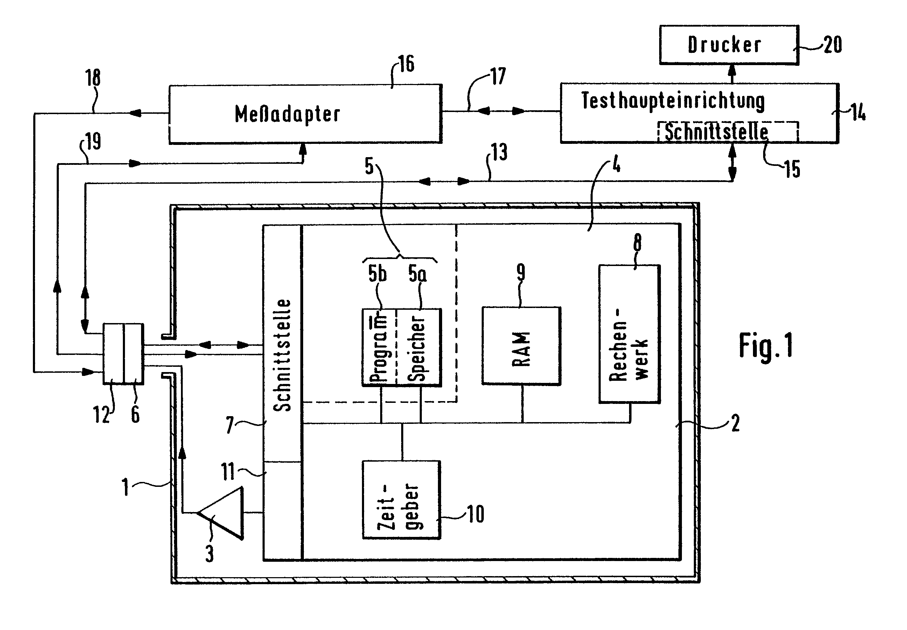

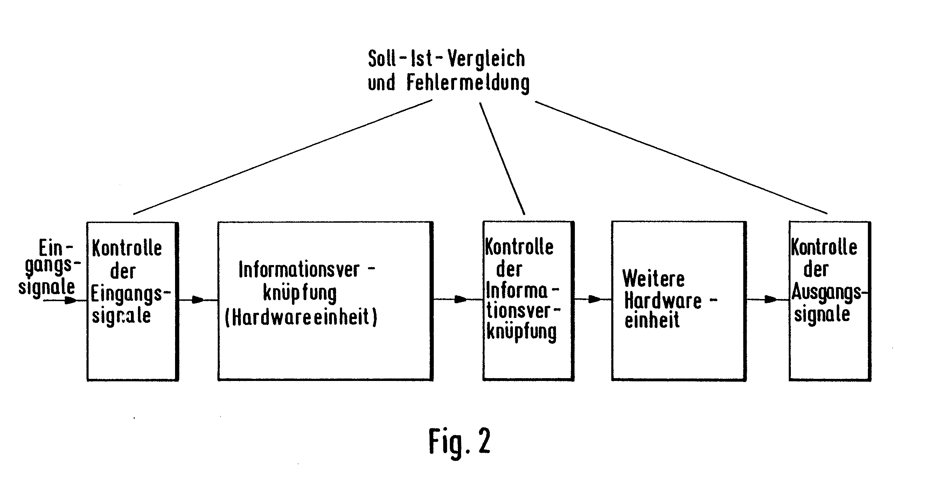

Fig. 2 den Signalweg des zu prüfenden Geräts in einer stark vereinfachten Darstellung.

In Fig. I ist mit I ein prüfbares elektronisches Gerät bezeichnet, welches einen Mikrocomputer 2 sowie als diesem nachgeschaltete Einheit einen Verstärker 3 umfaßt. Der Mikrocomputer besteht im wesentlichen aus einem Prozessor 4 und einem Programmspeicher 5, der als EROM ausgebildet ist. Der Programmspeicher ist in einen Speicherbereich 5a für ein Hauptprogramm und in einen Speicherbereich 5b für ein Testprogramm unterteilt.

Bestandteil des Geräts ist weiterhin ein Stecker 6 mit nicht dargestellten Steckkontakten, welche die Eingänge des Geräts darstellen, sowie mit ebenfalls nicht dargestell ten Steckkontakten, welche die Ausgänge an dem Verstärker 3 repräsentieren. Der Stecker ist über eine funktionelle Schnittstelle 7 mit dem Prozessor, und zwar mit dessem Rechenwerk 8, RAM Speicher 9 sowie dessen Zeitgeber IO verbunden; außerdem steht die Schnittstelle mit beiden Bereichen des Programmspeichers 5 in Verbindung. Weiterhin ist ein Ausgangskontakt des Steckers 6 an den Ausgang des Verstärkers 3 angeschlossen, dessen Eingang durch den Prozessor über einen Umsetzer II gespeist wird.

Der Stecker 6 paßt in einen Gegenstecker I2, von dem mindestens eine Leitung I3 einer seriellen Verbindung zu einer Testhaupteinrichtung I4 führt. Diese weist ebenfalls eine Schnittstelle I5 auf, welche mit der Schnittstelle 7 korrespondieren kann. Die Testhaupteinrichtung ist zur Durchführung eines Soll-Ist Vergleichs und zur Aktivierung des Testprogramms in dem Gerät I ausgebildet. Die Testhaupteinrichtung steht mit einem Meßadapter I6 über eine Leitung I7 in Verbindung, so daß der Meßadapter, wenn ein entsprechendes Steuersignal von der Testhaupteinrichtung abgegeben wird, ein Eingangssignal auf einer Eingangssignal leitung I8 erzeugt, die über den Gegenstecker I2 mit dem Stecker 6 in Verbindung steht. Von dem Gegenstecker I2 führt eine Ausgangssignalleitung I9 wiederum zu dem Meßadapter, der aus den Ausgangssignalen Signale bzw. Daten erzeugt, die in der Testhaupteinrichtung dem Soll-Ist Wertvergleich zugrundegelegt werden können. Das Ergebnis des Soll-Ist-Vergleichs wird mit einem Drucker 20 dokumentiert.

Zur nacheinanderfolgenden Prüfung einzelner Hardware-Einheiten des prüfbaren Geräts I einschließlich des Steckers 6 wird durch die Testhaupteinrichtung über die Leitung I3 ein Testprogramm in dem Programmspeicher 5 aktiviert. Außerdem gibt die Testhaupteinrichtung über die Meßadapterleitung I7 ein Signal an den Meßadapter, welches in einem ersten Prüfschritt eine Kombination von Eingangssignalen über die Eingangssignalleitung I8 an den Stecker 6 abgibt. Über die von der Testhaupteinrichtung und dem Testprogramm in dem Programmspeicher 5 gesteuerte Schnittstelle 7 werden die an dem Prozessor 4 auftretenden Eingangssignale als Testausgangssignale zu der Testhaupteinrichtung I4 rückgemeldet und dort dem Soll-Ist Vergleich zugrunde gelegt.

Anschließend werden in weiteren Prüfschritten, die von dem Testprogramm vorgegeben werden, Teststeuersignale erzeugt, mit denen der Programmspeicher und der Prozessor nacheinander Hardware-mäßig geprüft werden. Dazu werden die Testausgangs signale dieser Hardware-Einheiten über die Schnittstelle in die Testhaupteinrichtung geleitet und dem Soll-Ist-Vergleich zugrunde gelegt. Ergänzt wird noch die Einzelheit, daß die Überprüfung des Zeitgebers IO in dem Prozessor 2 dadurch erfolgt, daß eine Zeitmessung zwischen Taktimpulsen durchgeführt wird und in der Testhaupteinrichtung die Zeitmessung durch Vergleich ausgewertet wird.

In einem weiteren Prüfschritt wird der Prozessor 4 von der Testhaupteinrichtung so angesteuert, daß von dem Verstärker 3 Ausgangssignale an den Stecker 6 abgegeben werden. Die Ausgangssignale gelangen über die Ausgangssignalleitung I9, um in solche Signale umgesetzt zu werden, die in der Testhaupteinrichtung einem Soll-Ist-Vergleich zugrunde gelegt werden können.

In Fig. 2 ist schematisch angedeutet, wie von links nach rechts gehend aufeinanderfolgend zunächst eine Kontrolle der Eingangssignale durchgeführt wird, sodann eine Kontrolle der Informationsverknüpfung und schließlich eine Kontrolle der Ausgangssignale.-Wesentlich ist die funktionsmäßige Trennung der Prüfung der Hardware-Einheiten von der Software (Hauptprogramm), die in dem Gerät keiner wesentlichen Prüfung mehr bedarf.

## Ansprüche

I. Prüfbares elektronisches Gerät, insbesondere für Kraftfahrzeuge, mit einem Mikrocomputer und einer Schnittstelle zum Anschluß an weitere Geräte, die an das prüfbare Gerät Eingangssignale abgeben bzw. Ausgangssignale von diesem empfangen,

**dadurch gekennzeichnet,**

daß einzelne Hardware-Einheiten (Prozessor 4, Programmspeicher (5) des Mikrocomputers (2)-,ausführende Einheiten) zur Prüfung über die Schnittstelle getrennt ansteuerbar sind und daß über die Schnittstelle die dabei von den Hardware-Einheiten erzeugten Testausgangssignale zu einem Soll-Ist-Vergleich extern zugänglich sind.

2. Prüfbares elektronisches Gerät nach Anspruch I,

**dadurch gekennzeichnet,**

daß der Mikrocomputer (2) einen Programmspeicher (5) umfaßt, in dem Teststeuerdaten eines Testprogramms gespeichert sind.

3. Prüfbares elektronisches Gerät nach Anspruch 2,

**gekennzeichnet durch**

einen Speicherbereich, in dem die Teststeuerdaten ständig gespeichert sind.

4. Prüfbares elektronisches Gerät nach Anspruch 2,

**gekennzeichnet durch**

einen löschbaren Speicherbereich (EROM 5b), in dem die Teststeuerdaten nur vor dem betriebsmäßigen Einsatz des Geräts gespeichert sind.

5. Verfahren zum Prüfen eines elektronischen Geräts, insbesondere für Kraftfahrzeuge, mit einem Mikrocomputer, einer Schnittstelle sowie Geräteein- und Ausgängen,

**dadurch gekennzeichnet,**

daß in getrennten Prüfschritten jeweils

    a) in die Geräteeingänge (Stecker 6) mindestens eine vorgegebene Kombination von Eingangssignalen eingespeist wird, die an Eingängen der Hardware-Einheiten (4, 8, 9) des Geräts (I) dabei auftretenden Testausgangssignale über die Schnittstelle abgefragt und extern mit der Kombination der Eingangssignale verglichen werden,

    b) in je eine Hardware-Einheit (5, 8, 9) Teststeuersignale eingespeist werden und die dadurch am Ausgang dieser Hardware-Einheit stehenden Testausgangssignale über die Schnittstelle zu einem externen Soll-Ist-Vergleich abgefragt werden,

    c) in wenigstens eine mit den Geräteausgängen (Stecker 6) in Verbindung stehende Hardware-Einheit (3, 4) Ausgangsteststeuersignale eingespeist werden und die dadurch an den Geräteausgängen erzeugte Ausgangssignale zu einem externen Soll-Ist-Vergleich abgegeben werden.

6. Verfahren nach Anspruch 5,

**dadurch gekennzeichnet,**

daß eines oder mehrere folgender Testausgangssignale zum externen Soll-Ist-Vergleich über die Schnittstelle des zu prüfenden Geräts (I) ausgegeben werden:

    b I) zur Prüfung eines Programmspeichers -(5) als Hardware-Einheit

    b II) Checksum-Signale

    b I2) Signale, mit denen das gesamte Hauptprogramm zum Soll-Ist-Vergleich ausgegeben wird.

    b 2) zur Prüfung des Mikroprozessors (4):

    b2I) RAM-Signale aus einem RAM-Speicher (9)

    b22) Zeitgeber-Signale aus einem Zeitgeber (I0)

    b23) Signale aus einem Rechenwerk (8), die durch ein Rechenbeispiel gebildet werden.

7. Prüfbares elektronisches Gerät nach Anspruch I,

**dadurch gekennzeichnet,**

daß die Schnittstelle des Geräts einen Stecker (6) des Geräts umfaßt.

**Fig.1**

0 234 273

Soll-Ist-Vergleich
und Fehlermeldung

| Ein-<br>gangs-<br>signale | Kontrolle<br>der<br>Eingangs-<br>signale | Informationsver -<br>knüpfung<br>(Hardwareeinheit) | Kontrolle<br>der<br>Informa -<br>tionsver -<br>knüpfung | Weitere<br>Hardware -<br>einheit | Kontrolle<br>der<br>Ausgangs-<br>signale |

**Fig. 2**

0 234 273